# EUROPEAN PATENT SPECIFICATION

(11) **EP 1 536 244 B1**
(45) Date of publication and mention of the grant of the patent: **13.01.2010**
(21) Application number: 03292959.8
(22) Date of filing: 27.11.2003
(51) Int. Cl.: G01R 31/3185

(54) **Dynamically configurable scan chain testing**
Dynamisch konfigurierbare Abtastprüfung
Test par balayage configurable de façon dynamique

(43) Date of publication of application: 01.06.2005
(73) Proprietor: TEXAS INSTRUMENTS INC., Dallas, Texas 75265 (US); TEXAS INSTRUMENTS FRANCE, 06271 Villeneuve Loubet Cedex, Nice (FR)
(72) Inventor: Paglieri, Alessandro, 18032 Imperia (IT)
(74) Representative: Holt, Michael

(56) References cited:
- US-A- 5 592 493
- US-A- 5 636 227
- US-A- 5 831 992
- US-B1- 6 557 129

## Description

### FIELD OF THE INVENTION

The present subject matter relates in general to electronic circuits and, more particularly, to an electronic circuit with a dynamically configurable scan path.

### BACKGROUND OF THE INVENTION

As integrated circuit designs become denser and more complicated, the need for testing increases. Scan path testing, in which test data is provided to various circuit modules and the resultant output Is compared to expected results, is a widely used and powerful testing scheme. Unfortunately, scan path testing is one of the larger costs involved in manufacturing an electronic device. Further, it can be difficult to develop a testing scheme for a particular integrated circuit that completely tests the circuit.

EP 1351 066 A1 (Paglieri, Alessandro, 08 October 2003) discloses a scan chain routing circuitry, the signal on an input scan port can propagate through multiplexers to any scan core.

### SUMMARY OF THE INVENTION

In accordance with the claimed embodiment, an integrated circuit, comprises a circuit under test, a plurality of scan chains coupled to the circuit under test and a dynamically configurable input selection logic that is coupled to the scan chains. The integrated circuit is **characterized in that** the dynamically configurable input selection logic receives two scan input bit streams and provides one of the scan input bit streams to any two of the scan chains in parallel and the other of the scan input bit streams to any other two scan chains in parallel in accordance with a dynamically controllable control signal.

The integrated circuit also may comprise a dynamically controllable output selection logic that selects various scan chain outputs for combining into a single scan output from the integrated circuit. With this architecture, multiple scan chains can be loaded In parallel in a dynamically flexible manner so as to permit the implementation any of a plurality of test configurations. Further, multiple scan chains may share a single pin on the integrated circuit.

### NOTATION AND NOMENCLATURE

Certain terms are used throughout the following description and claims to refer to particular system components. As one skilled in the art will appreciate, various companies may refer to a component by different names. This document does not intend to distinguish between components that differ in name but not function. In the following discussion and in the claims, the terms "including" and "comprising" are used in an openended fashion, and thus should be interpreted to mean "including, but not limited to." Also, the term "couple" or "couples" is intended to mean either an indirect or direct connection. Thus, if a first device couples to a second device, that connection may be through a direct connection, or through an indirect connection via other devices and connections.

### BRIEF DESCRIPTION OF THE DRAWINGS

For a more detailed description of the preferred embodiments of the present invention, reference will now be made to the accompanying drawings, wherein:

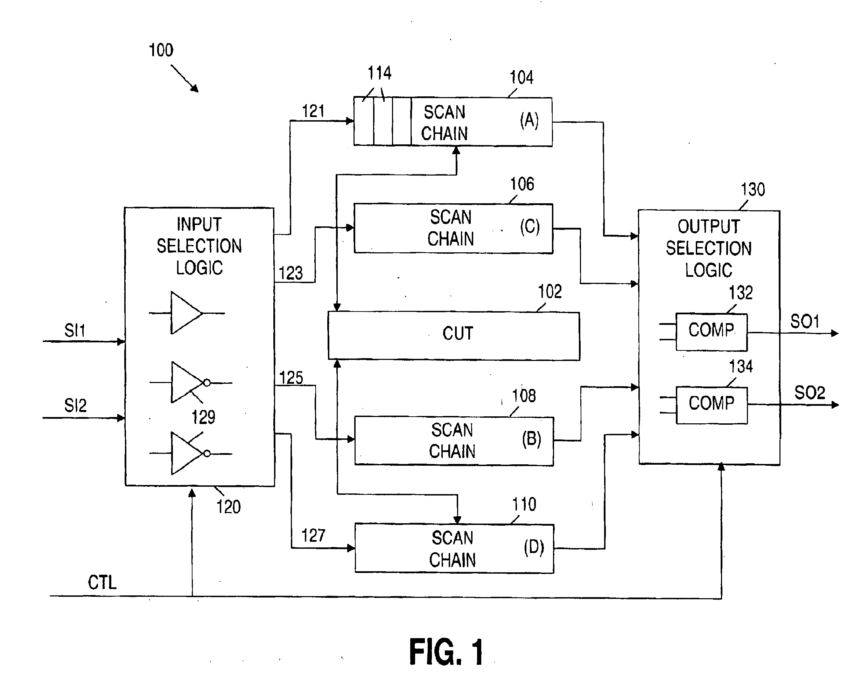

Figure 1 depicts an integrated circuit comprising a circuit under test and dynamically configurable scan path testing circuitry.

### DETAILED DESCRIPTION OF THE PREFERRED EMBODIMENTS

Figure 1 depicts an integrated circuit ("IC") 100 in accordance with a preferred embodiment of the invention. As shown, the IC comprises a circuit under test ("CUT") 102 which may include some or all of the functional circuitry of the IC. In general, IC 100 comprises sequential elements and combinatorial logic and the CUT 102 comprises the IC's combinatorial logic. The IC 100 may be any desired IC to be tested such as, without limitation a digital signal processor. As the name implies, the circuit under test 102 is the combinatorial logic of IC 100 that is being tested in accordance with the preferred embodiments discussed herein.

The IC 100 of Figure 1 also includes one or more scan chains 104, 106, 108, and 110. Each scan chain preferably comprises one or more sequential elements (e.g., shift registers 114) as is commonly known. Each scan chain 104-110 may comprise a complete scan chain or a segment of a longer scan chain. The shift registers 114 of the scan chains 104-110 couple to the CUT 102. Test data may be provided through the scan inputs (SI1 and SI2), through input selection logic 120, through the scan chains 104-106 and to the CUT 102. Outputs from the CUT 102 are provided via the scan chains to the output selection logic 130 and out of the IC 100 via the scan outputs (SO1 and SO2). Each scan input SI1, SI2 is provided to the IC 100 via a pin (not specifically shown) on the IC. As such, the IC 100 requires two pins for the scan inputs in the example of Figure 1. Similarly, the IC 100 provides two output pins (not specifically shown) for accessing the scan outputs SO1 and SO2.

The scan chain testing scheme depicted in Figure 1 permits multiple scan chains to be loaded in parallel in any of a plurality of dynamically controllable configurations. The SI1 test input bit stream may be provided to any two of the scan chains 104-110 shown in Figure 1. The SI2 test input bit stream may be provided to the other two scan chains (and thus also to any two scan chains). For example, the SI1 bit stream may be provided to scan chains 104 and 106, while the SI2 bit stream may be provided to scan chains 108 and 110. Continuing this example, the data loaded into scan chains 104 and 106 would be the same, but different than the data loaded into scan chains 108 and 110. Once the data is operated on by the CUT 102, the output from the scan chains is provided in parallel to the output selection logic 130 which comprises two compression circuits 132 and 134. Each compression circuit combines two bit streams from two of the scan chains into a single output bit stream. Compression circuit 132 thus combines two bit streams from scan chains 104-110 into a single output bit stream SO1. Similarly, compression circuit 134 combines the other two bit streams from the scan chains into a single output bit stream SO2. In this way, four scan chains 104-110 can be used to test the CUT 102 while only requiring two scan input pins and two scan output pins. The compression circuits 132 and 134 may comprise any suitable circuits such as exclusive OR logic gates. The scan outputs SO1 and SO2 are then compared to predicted patterns to determine whether an error occurred during testing.

The input selection logic 120 shown in Figure 1 permits the dynamic implementation of any of a plurality of test configurations. In this context, "dynamic" refers to implementing a test configuration for the integrated circuit after the integrated circuit has been fabricated and being able to change the test configuration as desired. The input selection logic 120 permits either input SI1 and SI2 to be provided to any of the four outputs 121, 123, 125, or 127 from the selection logic. Thus, the input selection logic permits each input SI1 or Si2 to be provided to any of the scan chains and to any pair of scan chains. Further, the input selection logic 120 comprises one or more dynamically selectable inverters 129 that can be used to logically invert either or both of the input bit streams SI1 or SI2. The control as to which scan inputs are provided which scan chains and whether inverters are to be used or not is dictated by the control signal ("CTL"). The CTL control signal may be generated internally to the IC 100 by a suitable test interface (e.g., JTAG). Alternatively, the CTL control signal may be generated external to the IC and provided to the input selection logic 120 via a pin on the IC.

The CTL control signal also configures the output selection logic 130 to provide any pair of the scan chain outputs to either compression circuit 132, 134. As such, if the input selection logic 120 is configured to provide the SI1 input bit stream to scan chains 106 and 108, then the output selection logic 130 may be configured to provide the outputs from scan chains 106 and 108 to the same compression circuit which may be either compression circuit 132 or 134.

With the dynamically configurable architecture described above and illustrated in Figure 1, a plurality of test configurations are possible. Being able to test the CUT 102 with a plurality of different configurations helps to ensure that a more complete test is performed on the CUT 102. Referring still to Figure 1, the scan chains 104-110 may be loaded with test data A, C, B, and D, respectively, as referenced in parentheses in the scan chains. The dynamically selectable nature of the input selection logic 120 and output selection logic 130 as well as the selectable inverters in the input selection logic 120 permits any of the exemplary configurations shown in Table I to be implemented during a test.

**Table 1. Exemplary Configurations**

| |
|---|
| (A=C) ≠(B= D) |
| (A= -C) ≠B= -D) |
| (A=B) ≠(C= D) |
| (A= -B) ≠(C= -D) |

The embodiments described herein enable a reduction in test time, compared to conventional scan chain testing schemes, in that multiple scan chains can be loaded and processed in parallel. Further, by loading multiple scan chains with the same test vectors, test data volume is reduced compared to conventional testing schemes.

While the preferred embodiments of the present invention have been shown and described, modifications thereof can be made by one skilled in the art without departing from the scope of the claimed invention. The embodiments described herein are exemplary only, and are not intended to be limiting. Many variations and modifications of the invention disclosed herein are possible and are within the scope of the invention. For instance, any number of scan chains may be implemented. Further, although a scan input bit stream is described as being provided to two scan chains in parallel, in other embodiments a scan input bit stream may be provided to only a single chan chain or more than two scan chains if desired. The single particular scan chain receiving the scan input bit stream is dictated by the dynamically controllable control signal. Accordingly, the scope of protection is not limited by the description set out above.

## Claims

1. An integrated circuit (100), comprising:
a circuit under test (102);
a plurality of scan chains (104, 106, 108, 110) coupled to the circuit under test (102); and
a dynamically configurable input selection logic (120) that is coupled to the scan chains, and **characterized in that**
said dynamically configurable input selection logic receives two scan input bit streams and provides one of the scan input bit streams to any two of the scan chains in parallel and the other of the scan input bit streams to any other two scan chains in parallel in accordance with a dynamically controllable control signal.

2. The integrated circuit of claim 1 further comprising a dynamically configurable output selection logic (130) that is coupled to the scan chains, receives two or more output bit streams from said scan chains, and compresses said two or more output bit streams into a single scan output bit stream, wherein the two or more output bit streams are selected from scan chains dictated by the dynamically controllable control signal.

3. The integrated circuit of claim 1 or claim 2 wherein the dynamically configurable input selection logic provides a common scan input bit stream to a pair of scan chains in accordance with the dynamically controllable control signal.

4. The integrated circuit of any one of claims 1 to 3 wherein the dynamically configurable input selection logic (120) comprises a selectable inverter (129) that permits a scan input bit stream to be logically inverted and thus an inverted form of a scan input bit stream to be provided to one or more scan chains.

5. A scan chain testing method, **characterized by** comprising:
receiving two scan input bit streams at an input selection logic (120) associated with an integrated circuit (100); and
asserting a control signal to the input selection logic associated with the integrated circuit (100) to cause the input selection logic (120) to provide one of the scan input test bit streams to any two scan chains (104, 106, 108, 110) in parallel and the other of the scan input bit streams to any other two scan chains in parallel dictated by the control signal.

6. The method of claim 5 further comprising combining outputs from a plurality of scan chains (104, 106, 108, 110) as dictated by the control signal.

7. The method of claim 5 or 6 wherein asserting a control signal comprises asserting a control signal to cause the input selection logic (120) to provide a common scan input test bit stream to any two of a plurality of scan chains (104, 106, 108, 110) as dictated by the control signal.

8. The method of any one of claims 5 to 7 wherein asserting a control signal comprises asserting a control signal to cause the input selection logic (120) to provide a first scan input test bit stream to any two of a plurality of scan chains (104, 106, 108, 110) as dictated by the control signal and to provide a second scan input test bit stream to any two of a plurality of other scan chains as dictated by the control signal.

9. The method of any one of claims 5 to 7 wherein asserting a control signal also comprises asserting a control signal to cause the input selection logic (120) to logically invert a scan input test bit stream to one or more scan chains.

## Patentansprüche

1. Integrierte Schaltung (100) mit:
einer zu prüfenden Schaltung (102),
mehreren Abtastketten (104, 106, 108, 110), die mit der zu prüfenden Schaltung (102) gekoppelt sind, und
einer dynamisch konfigurierbaren Eingangsauswahllogik (120), die mit den Abtastketten gekoppelt ist, und **dadurch gekennzeichnet, dass**
die dynamisch konfigurierbare Eingangsauswahllogik zwei Abtasteingangsbitströme empfängt und in Übereinstimmung mit einem dynamisch steuerbaren Steuersignal einen der Abtasteingangsbitströme zwei beliebigen der Abtastketten und den anderen der Abtasteingangsbitströme zwei beliebigen anderen Abtastketten parallel zuführt.

2. Integrierte Schaltung nach Anspruch 1, ferner mit einer dynamisch konfigurierbaren Ausgangsauswahllogik (130), die mit den Abtastketten gekoppelt ist, zwei oder mehr Ausgangsbitströme von den Abtastketten empfängt und die zwei oder mehr Ausgangsbitströme in einen einzigen Abtastausgangsbitstrom komprimiert, wobei die zwei oder mehr Ausgangsbitströme nach Maßgabe des dynamisch steuerbaren Steuersignals aus Abtastketten ausgewählt sind.

3. Integrierte Schaltung nach Anspruch 1 oder Anspruch 2, bei der die dynamisch konfigurierbare Eingangsauswahllogik in Übereinstimmung mit dem dynamisch steuerbaren Steuersignal einem Paar Abtastketten einen gemeinsamen Abtasteingangsbitstrom zuführt.

4. Integrierte Schaltung nach einem der Ansprüche 1 bis 3, bei der die dynamisch konfigurierbare Eingangsauswahllogik (120) einen auswählbaren Inverter (129) umfasst, der ermöglicht, dass ein Abtasteingangsbitstrom logisch invertiert wird und somit einer oder mehreren Abtastketten eine invertierte Form eines Abtasteingangsbitstroms zugeführt wird.

5. Abtastkettenprüfverfahren, **dadurch gekennzeichnet, dass** es folgendes umfasst:
an einer zu einer integrierten Schaltung (100) gehörigen Eingangsauswahllogik (120) werden zwei Abtasteingangsbitströme empfangen, und
ein Steuersignal an die zu der integrierten Schaltung (100) gehörige Eingangsauswahllogik wird für gültig erklärt, um die Eingangsauswahllogik (120) zu veranlassen, nach Maßgabe des Steuersignals zwei beliebigen Abtastketten (104, 106, 108, 110) einen der Abtasteingangsprüfbitströme parallel zuzuführen und zwei beliebigen anderen Abtastketten den anderen der Abtasteingangsbitströme parallel zuzuführen.

6. Verfahren nach Anspruch 5, bei dem ferner Ausgänge aus mehreren Abtastketten (104, 106, 108, 110) nach Maßgabe des Steuersignals zusammengefasst werden.

7. Verfahren nach Anspruch 5 oder 6, bei dem bei der Gültigkeitserklärung eines Steuersignals ein Steuersignal für gültig erklärt wird, um die Eingangsauswahllogik (120) zu veranlassen, nach Maßgabe des Steuersignals zwei beliebigen aus mehreren Abtastketten (104, 106, 108, 110) einen gemeinsamen Abtasteingangsprüfbitstrom zuzuführen.

8. Verfahren nach einem der Ansprüche 5 bis 7, bei dem bei der Gültigkeitserklärung eines Steuersignals ein Steuersignal für gültig erklärt wird, um die Eingangsauswahllogik (120) zu veranlassen, nach Maßgabe des Steuersignals zwei beliebigen aus mehreren Abtastketten (104, 106, 108, 110) einen ersten Abtasteingangsprüfbitstrom zuzuführen und nach Maßgabe des Steuersignals zwei beliebigen aus mehreren anderen Abtastketten einen zweiten Abtasteingangsprüfbitstrom zuzuführen.

9. Verfahren nach einem der Ansprüche 5 bis 7, bei dem bei der Gültigkeitserklärung eines Steuersignals auch ein Steuersignal für gültig erklärt wird, um die Eingangsauswahllogik (120) zu veranlassen, einen Abtasteingangsprüfbitstrom an eine oder mehrere Abtastketten logisch zu invertieren.

## Revendications

1. Circuit intégré (100), comprenant :
un circuit en test (102) ;
une pluralité de chaînes de balayage (104, 106, 108, 110) couplées au circuit en test (102) ; et
une logique de sélection d'entrée configurable de manière dynamique (120) qui est couplée aux chaînes de balayage, et **caractérisé en ce que :**
ladite logique de sélection d'entrée configurable de manière dynamique reçoit deux trains de bits d'entrée de balayage, et délivre l'un des trains de bits d'entrée de balayage à deux chaînes quelconques de balayage en parallèle, et l'autre des trains de bits d'entrée de balayage à deux autres chaînes quelconques de balayage en parallèle selon un signal de commande contrôlable de manière dynamique.

2. Circuit intégré selon la revendication 1, comprenant en outre une logique de sélection de sortie configurable de manière dynamique (130) qui est couplée aux chaînes de balayage, reçoit deux trains de bits de sortie ou plus en provenance desdites chaînes de balayage, et compresse lesdits deux trains de bits de sortie ou plus en un seul train de bits de sortie de balayage, dans lequel les deux trains de bits de sortie ou plus, sont sélectionnés parmi des chaînes de balayage imposées par le signal de commande contrôlable de manière dynamique.

3. Circuit intégré selon la revendication 1 ou la revendication 2, dans lequel la logique de sélection d'entrée configurable de manière dynamique délivre un train de bits d'entrée de balayage commun à une paire de chaînes de balayage selon le signal de commande contrôlable de manière dynamique.

4. Circuit intégré selon l'une quelconque des revendications 1 à 3, dans lequel la logique de sélection d'entrée configurable de manière dynamique (120), comprend un inverseur pouvant être sélectionné (129) qui permet d'inverser de manière logique un train de bits d'entrée de balayage, et ainsi de délivrer une forme inversée d'un train de bits d'entrée de balayage, à une ou plusieurs chaînes de balayage.

5. Procédé de test d'une chaîne de balayage, **caractérisé par** les étapes consistant à :
recevoir deux trains de bits d'entrée de balayage au niveau d'une logique de sélection d'entrée (120) associée à un circuit intégré (100) ; et
imposer un signal de commande à la logique de sélection d'entrée associée au circuit intégré (100) pour que la logique de sélection d'entrée (120) délivre l'un des trains de bits de test d'entrée de balayage à deux chaînes quelconques de balayage (104, 106, 108, 110) en parallèle, et l'autre des trains de bits d'entrée de balayage à deux autres chaînes quelconques de balayage en parallèle, comme l'impose le signal de commande.

6. Procédé selon la revendication 5, comprenant en outre une combinaison des sorties en provenance d'une pluralité de chaînes de balayage (104, 106, 108, 110), comme l'impose le signal de commande.

7. Procédé selon la revendication 5 ou la revendication 6, dans lequel le fait d'imposer un signal de commande entraîne le fait que cela provoque la délivrance, par la logique de sélection d'entrée (120), d'un train de bits de test d'entrée de balayage commun à deux chaînes quelconques d'une pluralité de chaînes de balayage (104, 106, 108, 110), comme l'impose le signal de commande.

8. Procédé selon l'une quelconque des revendications 5 à 7, dans lequel le fait d'imposer un signal de commande entraîne le fait que cela provoque la délivrance, par la logique de sélection d'entrée (120), d'un premier train de bits de test d'entrée de balayage à deux quelconques d'une pluralité de chaînes de balayage (104, 106, 108, 110), comme l'impose le signal de commande, et la délivrance d'un second train de bits de test d'entrée de balayage à deux quelconques d'une pluralité d'autres chaînes de balayage, comme l'impose le signal de commande.

9. Procédé selon l'une quelconque des revendications 5 à 7, dans lequel le fait d'imposer un signal de commande entraîne également le fait que cela provoque une inversion logique, par la logique de sélection d'entrée (120), d'un train de bits de test d'entrée de balayage vers une ou plusieurs chaînes de balayage.
